# EUROPEAN PATENT APPLICATION

(11) **EP 2 471 624 A1**
(43) Date of publication of application: **04.07.2012**
(21) Application number: 11250714.0
(22) Date of filing: 09.08.2011
(51) Int. Cl.: B23K 20/00, H01L 25/065

(54) **Continuous wire bonding**

(30) Priority: 04.01.2011 WO PCT/CN2011/070019
(71) Applicant: SanDisk Semiconductor (Shanghai) Co., Ltd., Minhang District Shanghai 200241 (CN); SanDisk Information Technology (Shanghai) Co., Ltd, Minhang District Shanghai 200241 (CN)
(72) Inventor: Lu, Zhong, Pudong District, Shanghai (CN); Yu, Fen, Minhang District, Shanghai 200241 (CN); Chiu, Chin Tien, Situn District 40767, Taichung City (TW); Yu, Cheeman, Fremont, California 94538 (US); Xiao, Fuqiang, Shanghai 200241 (CN)
(74) Representative: Tothill, John Paul

(57) **Abstract**

A wire bonded structure (100) for a semiconductor device is disclosed. The wire bonded structure (100) comprises a bonding pad (102); a conductive bump (104) disposed on the bonding pad (102), the conductive bump (104) including a concave top surface (106); and a continuous length of wire (110) mutually diffused with the concave top surface (106) of the conductive bump (104). The wire (110) electrically couples the bonding pad (102) with a first electrical contact and a second electrical contact different from the first electrical contact.

## Description

### Field

The present technology relates to fabrication of semiconductor devices.

### Description of Related Art

Wire bonding is a primary method of electrically coupling two separate electronic components such as semiconductor die or a substrate during semiconductor device fabrication.

During a wire bonding process, a length of wire (typically gold or copper) is fed through a central cavity of a needle-like disposable tool called the capillary. The wire protrudes through a tip of the capillary, where a high-voltage electric charge is applied to the wire from a transducer associated with the capillary tip. The electric charge melts the wire at the tip and the wire forms into a ball owing to the surface tension of the molten metal. As the ball solidifies, the capillary is lowered to the bonding surface and ultrasonic energy is applied by the transducer. The bonding surface can also be heated to facilitate bonding. The combined heat, pressure, and ultrasonic energy create a weld between the copper or gold ball and the bonding surface. The capillary is then pulled up and away from the bonding surface, as the wire is passed out through the capillary. The resulting bond is referred as a ball bond. The bonding surface may be a die bonding pad of a semiconductor die, a contact pad of a substrate, or even another previous formed ball bond structure.

The capillary carrying the wire then moves over to another bonding surface such as next die bonding pad of adjacent semiconductor die or a contact pad of substrate, and descends and crushes the wire by touching the bonding surface to make the wire bond again using heat, pressure and ultrasonic energy. The capillary then pays out a small length of wire and tears the wire from the bonding surface. The resulting bond is referred as a wedge bond, or a stitch bond.

### SUMMARY

In one aspect, the present technology relates to a wire bonded structure for a semiconductor device. The wire bonded structure comprises a bonding pad; a conductive bump disposed on the bonding pad, the conductive bump including a concave top surface; and a continuous length of wire mutually diffused with the concave top surface of the conductive bump. The wire electrically couples the bonding pad with a first electrical contact and a second electrical contact different from the first electrical contact.

In embodiments, the bonding pad preferably comprises a die bonding pad of a semiconductor die or a contact pad of a substrate. The substrate preferably comprises printed circuit board (PCB), leadframe and/or Tape Automated Bonding (TAB) tape. The bonding pad preferably comprises gold or aluminum. The conductive bump preferably comprises gold or copper. The conductive bump preferably has a drum-like shape. The ratio of the maximum width of the conductive bump to the height of conductive bump preferably is about 3-6.

In embodiments, the continuous length of wire preferably has a first portion for electrically coupling the bonding pad with the first electrical contact, a contact portion contacting the concave top surface of the conductive bump and mutually diffused with the concave top surface of the conductive bump, and a second portion for electrically coupling the bonding pad with the second electrical contact. The contact portion of the wire preferably has a smaller diameter than the diameter of the first and second portion of the wire. The first portion of the wire preferably has an angle of about 15° to 45° relative to a reference plane parallel to the bonding pad and the second portion of the wire preferably has an angle of about 5° to 30° relative to the reference plane.

In embodiments, the wire preferably comprises gold, aluminum or copper. The first and second electrical contacts preferably comprise a die bonding pad, a contact pad, a conductive bump or a bonding wire.

In another aspect, the present technology relates to a wire bonded structure for a semiconductor device. The wire bonded structure comprises a bonding pad; a conductive bump disposed on the bonding pad, the conductive bump including a top surface; and a continuous length of wire. The continuous length of wire includes a first portion electrically coupled with a first electrical contact; a second portion electrically coupled with a second electrical contact; and a contact portion between the first portion and the second portion, the contact portion mutually diffused with the top surface.

In another aspect, the present technology relates to a semiconductor device. The device comprises a first semiconductor die including a first die bonding pad; a second semiconductor die including a second die bonding pad; a component including an electrical contact, the second semiconductor die affixing to the component; a conductive bump affixed on the second die bonding pad of the second semiconductor die, the conductive bump including a top surface; and a continuous length of wire bonded to the top surface, the wire electrically coupling the second die bonding pad of the second semiconductor die with the first die bonding pad of the first semiconductor die and the electrical contact of the component.

In embodiments, the component may be a substrate and the electrical contact may be a contact pad. The substrate preferably comprises printed circuit board (PCB), leadframe and/or Tape Automated Bonding (TAB) tape.

In embodiments, the component can be a third semiconductor die and the electrical contact can be a third die bonding pad. The device preferably further comprises a second conductive bump affixed on the third die bonding pad of the third semiconductor die, the second conductive bump including a top surface, wherein the continuous length of wire is wire bonded to the top surface of the second conductive bump.

In embodiments, the continuous length of wire preferably has a first portion for electrically coupling the second die bonding pad with the first die bonding pad, a contact portion contacting the conductive bump and mutually diffused with the top surface of the conductive bump, and a second portion for electrically coupling the second die bonding pad with the electrical contact. The contact portion of the wire preferably has a smaller diameter than the diameter of the first and second portion of the wire. The first portion of the wire preferably has an angle of about 15° to 45° relative to a reference plane parallel to the bonding pad and the second portion of the wire preferably has an angle of about 5° to 30° relative to the reference plane.

In yet another aspect, the present technology relates to a method of forming a wire bonded structure on a bonding pad of a semiconductor device. The method comprises: affixing a conductive bump on the bond pad, the conductive bump having a top surface; and mutually diffusing a continuous length of wire with the top surface of the conductive bump to thereby electrically couple the bonding pad with a first electrical contact and a second electrical contact different from the first electrical contact.

In embodiments, after the step of affixing a conductive bump on the bonding pad, preferably the top surface of the conductive bump is substantially flat.

In embodiments, the step of mutually diffusing a continuous length of wire with the top surface of the conductive bump preferably comprises pressing the continuous length of wire against the top surface of the conductive bump with a force applied by a wire bonding device at an elevated temperature. The force may be 10-200 gram-force (0.098-1.961N). The temperature may be about 150-175 °C. During the step of mutually diffusing a continuous length of wire with the top surface of the conductive bump, preferably an ultrasonic energy with a power of about 0-300 mW is applied, and the wire bonding device preferably does not touch the top surface of the conductive bump. The step of mutually diffusing a continuous length of wire with the top surface of the conductive bump preferably takes about 80-200 milliseconds. After the step of mutually diffusing a continuous length of wire with the top surface of the conductive bump, preferably the top surface of the conductive bump becomes concave.

In yet another aspect, the present technology relates to a method of forming a wire bonded structure between a bonding pad of a semiconductor device and the continuous length of wire. The continuous length of wire includes a first portion electrically coupled with a first electrical contact, a second portion electrically coupled with a second electrical contact, and a contact portion between the first portion and the second portion. The method comprises: affixing a conductive bump on the bond pad, the conductive bump having a top surface; and mutually diffusing the contact portion of the continuous length of wire with the top surface of the conductive bump to thereby electrically couple the bonding pad with the first and the second electrical contacts.

In yet another aspect, the present technology relates to a method of fabricating a semiconductor device. The method comprises the steps of: (a) affixing a group of semiconductor dies to a substrate, the group of semiconductor dies including a top semiconductor die and one or more intermediate semiconductor dies between the top semiconductor die and the substrate, each semiconductor die in the group of semiconductor die including a die bonding pad, and the substrate including a contact pad; (b) affixing a conductive bump on each of the die bonding pads of the one or more intermediate semiconductor dies, each conductive bump including a top surface; and (c) electrically coupling the die bonding pad of the top semiconductor die to the top surfaces of the conductive bumps on the die bonding pads of the one or more semiconductor dies and to the contact pad of the substrate by bonding a continuous length of wire on the top surfaces of the conductive bumps.

In embodiments, the step of bonding a continuous length of wire on the top surfaces of the conductive bumps preferably comprises mutually diffusing the continuous length of wire with the top surfaces of the conductive bumps.

### DESCRIPTION OF THE DRAWINGS

FIGS. 1A and 1B are a schematic side view and a schematic top view of a bond according to an embodiment of the present technology, respectively.

FIG. 2A is a schematic side view of a wire bonding device used in a continuous wire bonding process according to an embodiment of the present technology.

FIG. 2B is a schematic side view illustrating a bump being disposed in a continuous wire bonding process according to an embodiment of the present technology.

FIGS. 2C-2E are side views illustrating a continuous length of wire bonded on top of the bump according to an embodiment of the present technology.

FIG. 3 is a perspective view illustrating a semiconductor device including two semiconductor dies and a substrate electrically coupled with the continuous wire bond according to an embodiment of the present technology.

FIGS. 4A-4E are side views illustrating a continuous wire bonding process for electrically coupling the semiconductor device shown in Fig. 3 according to an embodiment of the present technology.

FIG. 5 is a perspective view illustrating a semiconductor device including three semiconductor dies and a substrate electrically coupled with the continuous wire bond according to another embodiment of the present technology.

### DETAILED DESCRIPTION

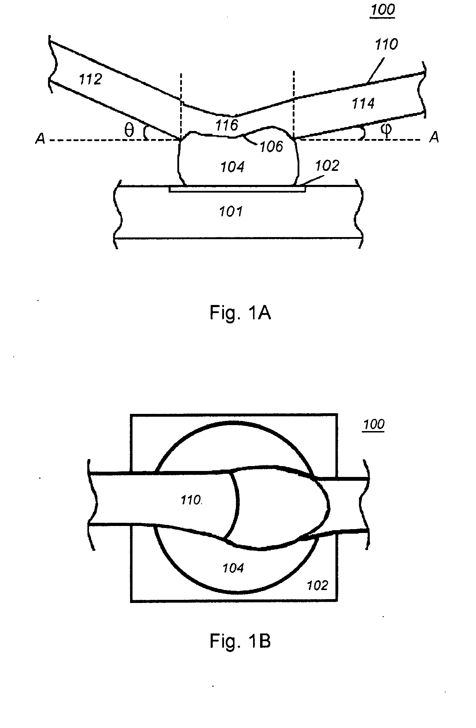

Embodiments will now be described with reference to Figs. 1 through 5, which relate to a continuous wire bond and semiconductor devices with the continuous wire bond and a method of electrically coupling semiconductor devices with continuous wire bond. It is understood that the present technology may be embodied in many different forms and should not be construed as being limited to the embodiments set forth herein. Rather, these embodiments are provided so that this disclosure will be thorough and complete and will fully convey the invention to those skilled in the art. Indeed, the present technology is intended to cover alternatives, modifications and equivalents of these embodiments, which are included within the scope and spirit of the invention as defined by the appended claims. Furthermore, in the following detailed description of the present technology, numerous specific details are set forth in order to provide a thorough understanding of the present technology. However, it will be clear to those of ordinary skill in the art that the present technology may be practiced without such specific details.

The terms "top," "bottom," "upper," "lower," "vertical" and/or "horizontal" as may be used herein are for convenience and illustrative purposes only, and are not meant to limit the description of the present technology inasmuch as the referenced item can be exchanged in position.

FIG. 1A and 1B show a schematic side view and a schematic top view of a wire bonded structure 100 of an embodiment of the present technology, respectively. The wire bonded structure 100 includes a bonding pad 102; a conductive bump 104 disposed on the bonding pad 102 and a continuous length of wire 110 bonded on top of the conductive bump 104.

The bonding pad 102 may be a semiconductor die bonding pad, in which case the wire bonded structure 100 is formed on the semiconductor die 101. The semiconductor die may comprise memory dies. Alternatively, the bonding pad 102 may be a contact pad of a substrate, in which case the wire bonded structure 100 is formed on the substrate 101. The substrate may comprise printed circuit board (PCB), leadframe and Tape Automated Bonding (TAB) tape. The bonding pad 102 may comprise gold or aluminum or gold-plated aluminum.

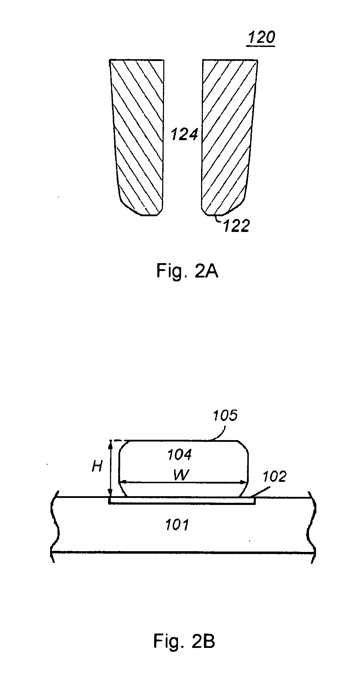

The conductive bump 104 preferably has a drum-like shape, that is, a substantially cylindrical shape with a convex sidewall. Referring to Figure 2B, the maximum width W and maximum height H of the conductive bump 104 depends on the bonding pad opening (BPO) size of the bonding pad 102, and the ratio of W/H of the conductive bump 104 is about 3-6. Referring again back to Figure 1A, the conductive bump 104 has a substantially flat bottom surface in order to securely rest on the bonding pad 102. When diffused with material from the wire 110 in a bonding process explained fully below, the conductive bump 104 preferably has a concave top surface 106 in order to increase contact area between the continuous length of wire 110 and the conductive bump 104. The conductive bump 104 may comprise gold, copper or gold and copper mixtures. The gold conductive bump 104 may comprise pure gold with purity ranging from 99% to 99.99%.

The wire 110 may be divided into a first portion 112, a second portion 114 and a contact portion 116, as shown in FIG. 1A. The first portion 112 is used to connect the bonding pad 102 with a first electrical contact (not shown) and the second portion 114 is used to connect the bonding pad 102 with a second electrical contact (not shown). The first electrical contact and the second electrical contact can be a die bonding pad of adjacent semiconductor die, contact pad of a substrate, or even a previously formed bond structure. As shown in FIG. 1A, the first portion 112 and the second portion 114 of the wire 110 have a substantially uniform diameter, which may be about 15 µm or less. The contact portion 116 of the wire 110 is flattened out during the wire bonding process according to the present technology, and thus bending lines are created in the wire 110 as shown in the FIG. 1B. In this case, the contact portion 116 of the wire 110 has a minimum diameter smaller than the diameter of the first and second portion 112 and 114 of the wire 110, as will be discussed in more detail hereafter. The first portion 112 has an inclined angle θ of 15° to 45° relative to a reference plane A parallel to the bonding pad 102, which is a horizontal plane in FIG. 1A. The second portion 114 has an inclined angle ϕ of 5° to 30° relative to the reference plane A. The wire 110 may comprise gold wire, copper wire or even aluminum wire. The wire 110 preferably comprise the same material as the bump 104, so that the bond strength between the wire 110 and the bonding pad 102 can be improved, especially in the case that the bonding pad 102 is made of metals (e.g. aluminum) other than the gold and copper typically used as material for the bond wire 110. Further details regarding the wire bonded structure 100 will be discussed with reference to a continuous wire bonding process for forming the wire bonded structure 100 as described below.

FIGS. 2A-2E are schematic side views illustrating a continuous wire bonding process for forming the wire bonded structure 100 shown in FIG. 1A according to an embodiment of the present technology. FIG. 2A shows a wire bonding device used in the continuous wire bonding process known as a capillary 120. The capillary 120 has a needle-like shape and includes a profiled needle head 122 and a central cavity 124 feeding the wire 110. The continuous length of wire 110 is fed through the capillary 120 during the continuous wire bonding process. The capillary 120 can also comprise a transducer (not shown) to apply current and ultrasonic energy.

As shown in FIG. 2B, the conductive bump 104 is disposed on the bonding pad 102. This can be accomplished as following. A ball made of gold, copper or alloy of gold and copper is formed at the tip of the capillary 120 and then is affixed on the bonding pad 102 under pressure applied by the capillary 120, while the transducer applies ultrasonic energy. In embodiments, the bond process may be further facilitated by heating the surface of the bonding pad 102 receiving the ball. The combined heat, pressure, and ultrasonic energy deforms the ball as the bump 104 and bond the bump 104 and the bonding pad 102. Then the capillary 120 is pulled up without paying out the wire, thus disposing the conductive bump 104 on the bonding pad 102. The conductive bump 104 has a drum-like shape and comprises gold, copper, or gold and copper mixtures. The as-deposited conductive bump 104 according to the present technology preferably has a substantially flat top surface 105, as compared to a convex top surface of a conductive bump for a conventional wire bonding. The flat top surface 105 improves the reliability of forming the wire bonded structure 100 by increasing the contact area between the conductive bump 104 and the wire subsequently bonded on top of the conductive bump 104 during the continuous wire bonding process. The flat top surface 105 can be obtained by adjusting pressure, temperature and ultrasonic energy upon disposing the bump 104.

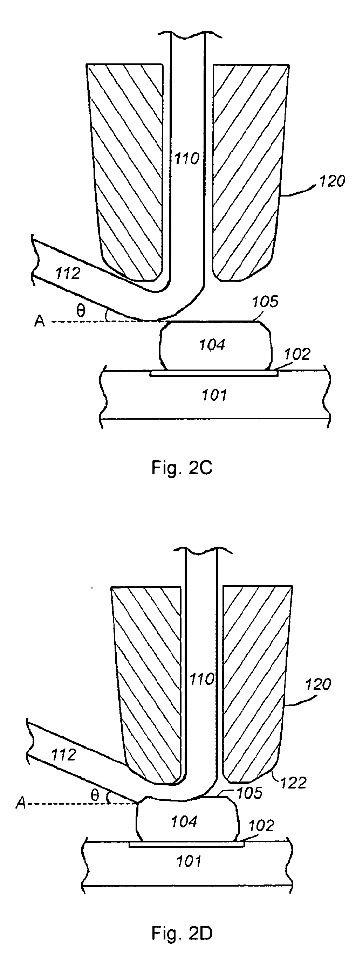

Next, as shown in FIG. 2C, the capillary 120 carrying a continuous length of wire 110 approaches the top surface of the conductive bump 104 at a relatively small angle compared with the conventional wire bonding process, thus the first portion 112 of the wire 110 connecting with a previous first electrical contact (not shown) has a relative smaller angle θ with reference to the reference plane A parallel to the bonding pad 102, which is the top surface of the conductive bump 104. In this case, it makes it possible for the wire 110 to have maximum contact with the substantially flat top surface of the conductive bump 104 upon forming the wire bonded structure 100. The angle θ of the first portion 112 relative to the bonding pad 102 is preferably about 15° to 45°.

As shown in FIG. 2D, the capillary 120 is then further lowered and presses the wire 110 against the top surface 105 with the profiled needle head 122 by applying a force at an elevated temperature. The force is preferably in the range of about 10-200 gram-force (0.098-1.961N), more preferably about 20-25 gram-force (0.196-0.245N). The temperature is preferably in the range of about 150°C-175°C, more preferably about 160°C. Since the melting temperature of gold and copper is 1063°C and 1083°C, respectively, both the wire 110 and the conductive bump 104 made of copper or gold do not melt during the continuous wire bonding process. Rather, the combination of the force and heat deforms both the contact portion 116 of the wire 110 and the top surface 105 of the conductive bump 104 and that forms an electrical and physical bond by mutual diffusion of materials in the contact portion 116 and the top surface 105. The contact portion 116 where the wire 110 contacts the top surface 105 of the conductive bump 104 has a smaller minimum diameter than the diameter of first portion 112 and the second portion 114 of the wire 110 due to such deformation. Unlike the stitch bond process, the needle head 122 of the capillary 120 does not touch the bonding surface, that is, the top surface 105 of the conductive bump 104, therefore, the wire 110 keeps continuity throughout the continuous wire bonding process, that is, the wire 110 keeps a continuous shape without being torn and is not crushed by the force applied by the capillary 120. The conductive bump 104 may be slightly deformed and the top surface 105 is deformed from a substantially flat surface to a concave surface. The deformation of the conductive bump 114 releases stress generated during the bonding process, thus reducing potential damage to the underneath bonding pad 102. Furthermore, an ultrasonic energy with a power of about 0-300 mW, preferably about 60-100 mW can be applied by a transducer (not shown) of the capillary 120 to facilitate the bonding process. The bonding process preferably takes about 80-200 milliseconds, more preferably about 100 milliseconds, for each wire bonded structure 100 in order to balance the throughput and reliability of the wire bonding process.

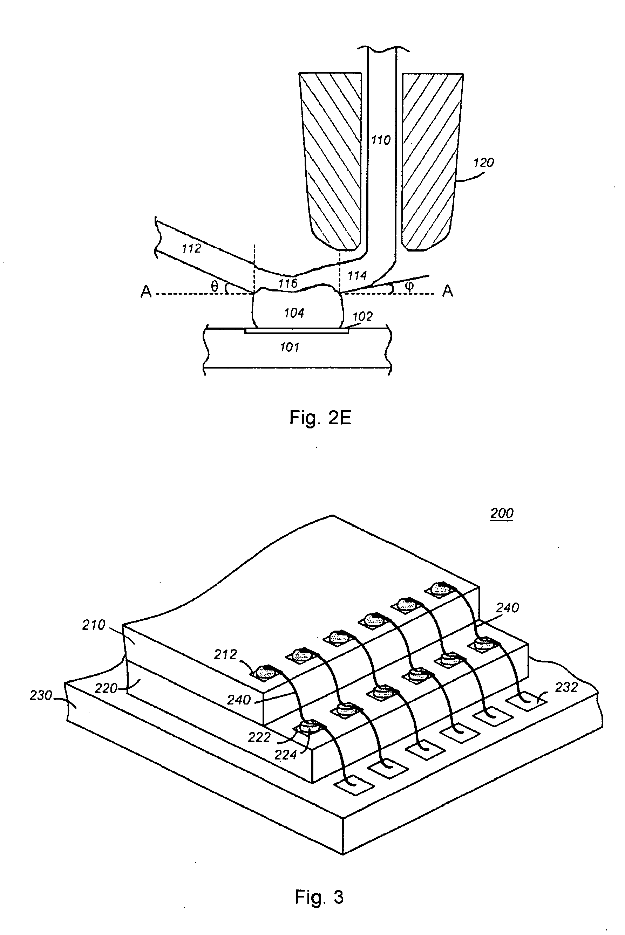

As shown in FIG. 2E, after the wire bonded structure is formed, the capillary 120 moves away from the conductive bump 104 at a relative small angle, so that the second portion 114 of the wire 110 connecting with the next second electrical contact preferably has an angle ϕ of about 5°-30° relative to the reference plane A parallel to the bonding pad 102 in order to improve reliability of the wire bonding process.

The wire bonded structure and the continuous wire bonding process according to the present technology as described above can be applied to various semiconductor devices for electrically coupling different components in the semiconductor devices. This will be further illustrated with examples hereafter.

FIG. 3 is a perspective view illustrating a semiconductor device 200 including two semiconductor dies and a substrate electrically coupled with the continuous wire bonding process according to the present technology. As shown in FIG. 3, the semiconductor device 200 comprises a first semiconductor die 210 and a second semiconductor die 220 and a substrate 230. The first semiconductor die 210 comprises a plurality of first die bonding pads 212, the second semiconductor 220 comprises a plurality of second die bonding pads 222 and the substrate 230 comprises a plurality of contact pads 232. The first semiconductor die 210, the second semiconductor die 220 and the substrate 230 are stacked sequentially in an offset configuration so that first die bonding pads 212 of the first semiconductor die 210, second die bonding pads 222 of the second semiconductor die 220 and contact pads 232 of the substrate 230 are exposed. The second semiconductor die 220 is electrically coupled to the first semiconductor die 210 and the substrate 230 by the continuous wire bonding process according to the present technology. A wire bonded structure as shown in FIG. 1A and 1B is formed on each second die bonding pad 222. Each wire bonded structure on the second die bonding pads 222 comprises a conductive bump 224 and a continuous length of wire 240 bonded on the top surface of the conductive bump 224 and connecting a corresponding first die bonding pad 212, second die bonding pad 222 and contact pad 232. It is understood that there may be many more bonding pads 212, 222, contact pads 232 and bond wires 240 than those shown in FIG. 3.

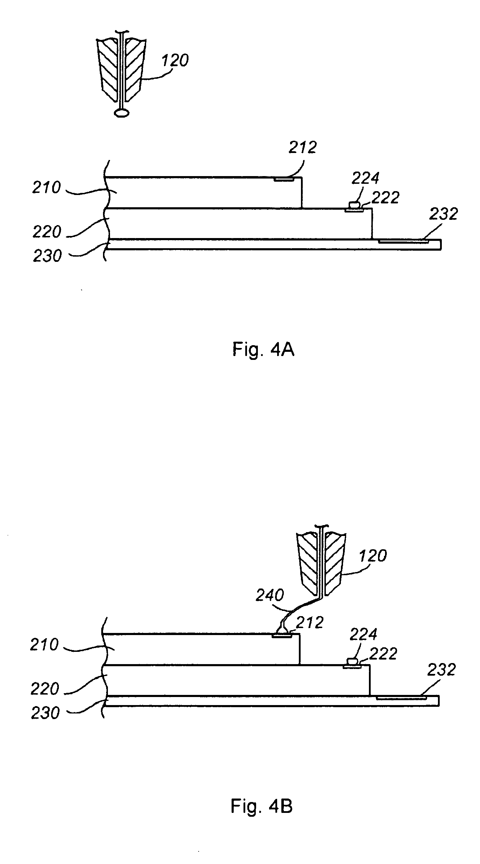

Further details regarding the semiconductor device 200 will be discussed with reference to a continuous wire bonding process for electrically coupling the semiconductor device 200 shown in FIGS. 4A-4E.

First, a conductive bump 224 is disposed on each second die bonding pad 222. Details of the process will not be repeated herein to avoid redundancy. After disposing each conductive bump 224, the capillary 120 moves back to a reference position. A ball made of gold, copper or an alloy of gold and copper is formed at the tip of the capillary again, as illustrated in FIG. 4A.

Next, as shown in FIG. 4B, the capillary moves over to the first die bonding pad 212 of the first semiconductor die 210 and perform a ball bond. In particular, the capillary 120 descends and presses the ball against the first die bonding pad 212, meanwhile ultrasonic energy is applied by the transducer. The first die bonding pad 212 can also be heated to facilitate bonding. The combined heat, pressure, and ultrasonic energy bond the ball and the first die bonding pad 212. The capillary 120 is then pulled up and away from the first die bonding pad 212, as a wire 240 is passed out through the capillary 120.

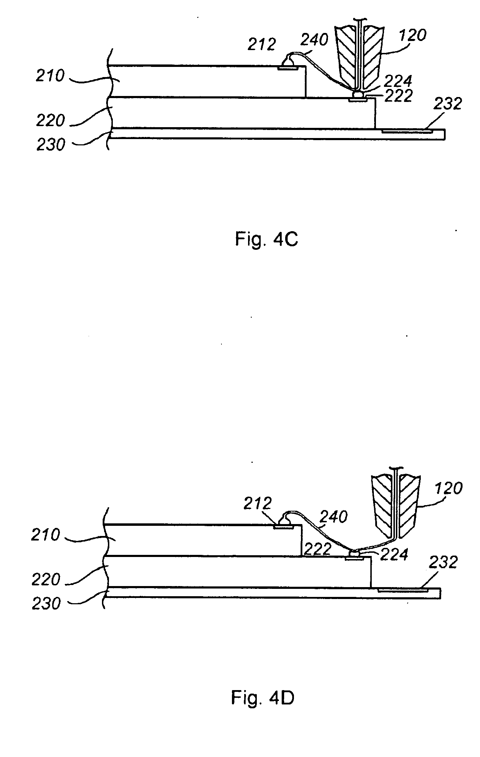

As shown in FIG. 4C, the capillary 120 moves over to the second die bonding pad 224 and performs a continuous wire bonding process as previously described.

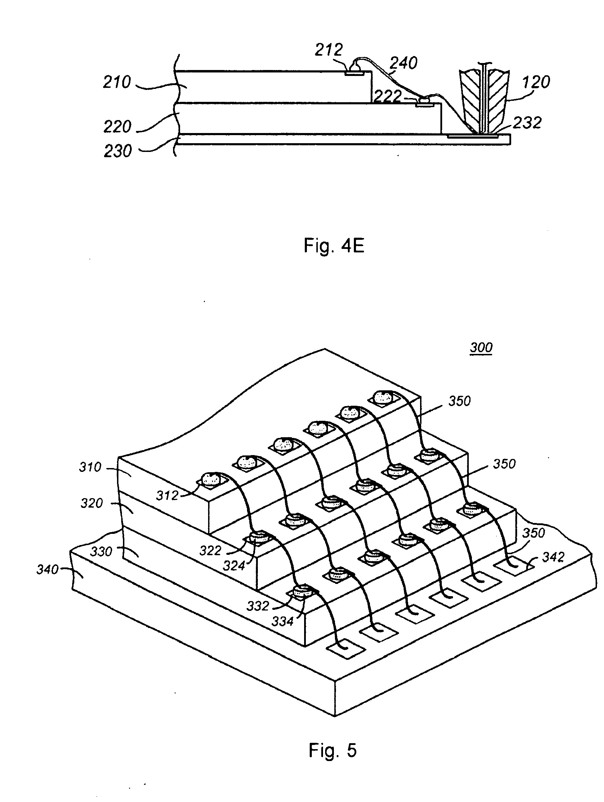

Next, as shown in FIG. 4D, the capillary 120 continuously pays out the wire 240 and moves over to the contact pad 232 of the substrate 230. Then, the capillary 120 bonds the wire 240 directly on the contact pad 232 by way of stitch bond, as shown in FIG. 4E.

The above-described continuous wire bonding process can be repeated for all die bonding pads of the semiconductor dies 210 and 220 and contact pads of the substrate 230 in the semiconductor device 200 as shown in the perspective view of FIG. 3.

During the continuous wire bonding process, the capillary 120 creates a concave top surface on the bump 224 upon touching the top surface of the bump 224. Such deformation of the bump 224 releases stress generated during wire bonding process, thus reducing potential damage to of underneath bonding pad 222. Furthermore, the bump 224 may also serve as a spacer member to prevent bond wire 240 from contacting corner portions of second semiconductor die 220 when looping from an upper component such as second semiconductor die 220 to a lower component such as the substrate 230, which otherwise might cause undesired shorting between upper and lower components.

The above-described continuous wire bonding process can also be applied to a semiconductor device including more than two semiconductor dies. For example, FIG. 5 shows a perspective view illustrating a semiconductor device 300 with three semiconductor dies 310, 320 and 330 and a substrate 340 electrically coupled with the continuous wire bonding process according to the present technology. As shown in FIG. 5, continuous wires 350 are bonded onto first bumps 324 on the second die bonding pads 322 of the second semiconductor die 320 and second bumps 334 on the third bonding pads 332 of the third semiconductor die 330, respectively. It is understood that the semiconductor device may include other numbers of semiconductor dies.

Electrically coupling a semiconductor device with multiple semiconductor dies using the continuous wire bond according to the present technology requires fewer steps and less fabrication time compared with a wire bonding process using conventional ball bond and stitch bond. For example, in conventional wire bonding process using ball bond or stitch bond, the capillary moves back to a reference point each time after performing the wire bonding. By contrast, in the continuous wire bond, the capillary makes consecutive wire bonds continuously with a continuous length of the bonding wire without moving the capillary back and forth from and to the reference position. Thus, it saves fabrication time by reducing capillary movements. For example, UPH (units per hour) can be improved by 16%, 22%, 26% and 28% for semiconductor devices with a 2-die stack, 4-die stack, 8-die stack and 16-die stack, respectively.

In embodiments described above, a wire bond is made between corresponding die bonding pads on respective semiconductor dies. As used herein, "corresponding" die bonding pads on different semiconductor dies refer to die bonding pads on different semiconductor dies that are aligned with each other along an edge of the dies including the die bonding pads. Thus, from the perspective of FIG. 5, the first (leftmost) die pad on each of dies 310, 320 and 330 correspond with each other and are wire bonded together, the second die pad from the left on each of semiconductor dies 310, 320 and 330 correspond with each other and are wire bonded together, etc. However, in further embodiments, the above-described continuous wire bond steps may be performed between diagonally oriented die bonding pads on respective die. For example, in FIG. 5, the leftmost die bonding pad of die 310 may be wire bonded in accordance with the above steps to the second die pad from the left on die 320.

Moreover, while embodiments described above show wire bonding between adjacent dies, it is understood that the present technology may be used to form a wire bond between die bonding pads on dies which are not adjacent to each other. Such wire bonds may be formed between corresponding die bonding pads on non-adjacent dies, or between diagonal die bonding pads on non-adjacent dies.

In addition, while in embodiments described above, the continuous wire bonding process is performed sequentially from the top semiconductor dies to the bottom substrate, it is understood that the continuous wire bonding process according to the present technology may also be applied reversely to form wire bonds sequentially from the lower substrate to the upper semiconductor dies. The bonding sequence of the semiconductor dies can also be adjusted depending on particular configuration.

The foregoing detailed description of the invention has been presented for purposes of illustration and description. It is not intended to be exhaustive or to limit the invention to the precise form disclosed. Many modifications and variations are possible in light of the above teaching. The described embodiments were chosen in order to best explain the principles of the invention and its practical application to thereby enable others skilled in the art to best utilize the invention in various embodiments and with various modifications as are suited to the particular use contemplated. It is intended that the scope of the invention be defined by the claims appended hereto.

## Claims

1. A wire bonded structure comprising:
a bonding pad (102);
a conductive bump (104) disposed on the bonding pad (102), the conductive bump (104) including a top surface (106); and
a continuous length of wire (110) for electrically coupling the bonding pad (102) with a first electrical contact and a second electrical contact different from the first electrical contact, the wire (110) being mutually diffused with the top surface (106) of the conductive bump (104).

2. The wire bonded structure of claim 1, wherein the bonding pad (102) is a die bonding pad of a semiconductor die or a contact pad of a substrate.

3. The wire bonded structure of claim 1 or 2, wherein the first and second electrical contact comprise die bonding pad, contact pad, conductive bump or bonding wire.

4. The wire bonded structure of claim 1, 2 or 3, wherein the continuous length of wire (110) has a first portion (112) for electrically coupling the bonding pad (102) with the first electrical contact, a contact portion (116) contacting the top surface (106) of the conductive bump (104) and mutually diffused with the top surface (106) of the conductive bump (104), and a second portion (114) for electrically coupling the bonding pad (102) with the second electrical contact.

5. A semiconductor device, comprising:
a first semiconductor die (210;310) including a first die bonding pad (212;312);
a second semiconductor die (220;320) including a second die bonding pad (222;322);
a component (230;330) including an electrical contact (232;332), the second semiconductor die (220;320) affixing to the component (230;330);
a conductive bump (224;324) affixed on the second die bonding pad (222;322) of the second semiconductor die (220;320), the conductive bump (224;324) including a top surface; and
a continuous length of wire (240;350) bonded to the top surface, the wire (240;350) electrically coupling the second die bonding pad (222;322) of the second semiconductor die (220;320) with the first die bonding pad (212;312) of the first semiconductor die (210;310) and the electrical contact (232;332) of the component (230;330).

6. The semiconductor device of claim 5, wherein the component is a substrate (230) and the electrical contact is a contact pad (232).

7. The semiconductor device of claim 5, wherein the component is a third semiconductor die (330) and the electrical contact is a third die bonding pad (332).

8. The semiconductor device of claim 7, further comprising a second conductive bump (334) affixed on the third die bonding pad (332) of the third semiconductor die (330), the second conductive bump (334) including a top surface, wherein the continuous length of wire (350) is wire bonded to the top surface of the second conductive bump (334).

9. The semiconductor device of any one of claims 5 to 8, wherein the continuous length of wire (240;350) has a first portion for electrically coupling the second die bonding pad (222;322) with the first die bonding pad (212;312), a contact portion contacting the conductive bump (224;324) and mutually diffused with the top surface of the conductive bump (224;324), and a second portion for electrically coupling the second die bonding pad (222;322) with the electrical contact (232;332).

10. The wire bonded structure of claim 4 or the semiconductor device of claim 9, wherein the contact portion (116) of the wire (110;240;350) has a smaller diameter than the diameter of the first (112) and second (114) portion of the wire (110;240;350).

11. The wire bonded structure of claim 4 or the semiconductor device of claim 9 or 10, wherein the first portion (112) of the wire (110;240;350) has an angle (θ) of about 15° to 45° relative to a reference plane (A) parallel to the bonding pad or pads and the second portion (116) of the wire (110;240;350) has an angle (ϕ) of about 5° to 30° relative to the reference plane (A).

12. The wire bonded structure or semiconductor device of any one of the preceding claims, wherein the conductive bump or each of the conductive bumps has a concave top surface.

13. The wire bonded structure or semiconductor device of any one of the preceding claims, wherein the conductive bump or each of the conductive bumps has a drum-like shape.

14. A method of forming a wire bonded structure comprising:
affixing a conductive bump (104) on a bonding pad (102), the conductive bump (104) having a top surface (106); and
bonding a continuous length of wire (110) on the top surface (106) of the conductive bump (104) to thereby electrically couple the bonding pad (102) with a first electrical contact and a second electrical contact different from the first electrical contact.

15. The method of claim 14, wherein the continuous length of wire (110) includes a first portion (112) electrically coupled with the first electrical contact, a second portion (114) electrically coupled with the second electrical contact, and a contact portion (116) between the first portion (112) and the second portion (114), the method comprising:
bonding the contact portion (116) of the continuous length of wire (110) with the top surface (106) of the conductive bump (104) to thereby electrically couple the bonding pad (102) with the first and the second electrical contacts.

16. A method of fabricating a semiconductor device comprising the steps of:
(a) affixing a group of semiconductor dies (210,220;310,320,330) to a substrate (230;340), the group of semiconductor dies (210,220;310,320,330) including a top semiconductor die (210;310) and one or more intermediate semiconductor dies (220;320,330) between the top semiconductor die (210;310) and the substrate (230;340), each semiconductor die in the group of semiconductor dies including a die bonding pad (222;322,332), and the substrate (230;340) including a contact pad (232;342);
(b) affixing a conductive bump (224;324,334) on each of the die bonding pads (222;322,332) of the one or more intermediate semiconductor dies (220;320,330), each conductive bump (224;324,334) including a top surface; and
(c) electrically coupling the die bonding pad (212;312) of the top semiconductor die (210;310) to the top surfaces of the conductive bumps (224;324,334) on the die bonding pads (222;322,332) of the one or more semiconductor dies (220;320,330) and to the contact pad (232;342) of the substrate (230;340) by bonding a continuous length of wire (240;350) on the top surfaces of the conductive bumps (224;324,334).

17. The method of claim 14, 15 or 16, wherein said step of bonding a continuous length of wire (110;240;350) on the top surface or surfaces of the conductive bump or bumps comprises mutually diffusing the continuous length of wire (110;240;350) with the top surface or surfaces of the conductive bump or bumps.

18. The method of any one of claims 14 to 17, wherein after said step of bonding a continuous length of wire (110;240;350) on the top surface or surfaces of the conductive bump or bumps, the top surface of the conductive bump becomes concave.
